Europäisches Patentamt

European Patent Office

Office européen des brevets

(19)

(11) Publication number: **0 042 894**
**B1**

(12) **EUROPEAN PATENT SPECIFICATION**

(45) Date of publication of patent specification: **02.05.84**

(21) Application number: **80302194.8**

(22) Date of filing: **30.06.80**

(51) Int. Cl.³: **H 01 L 21/00, G 03 F 7/02,**
**H 05 K 3/06**

(54) A process for forming microcircuits.

(43) Date of publication of application:
**06.01.82 Bulletin 82/1**

(45) Publication of the grant of the patent:
**02.05.84 Bulletin 84/18**

(84) Designated Contracting States:
**DE FR GB IT**

(56) References cited:
**DE - A - 2 755 064**
**US - A - 4 007 047**
**US - A - 4 069 076**
**US - A - 4 094 679**

(73) Proprietor: **International Business Machines**
**Corporation**
**Old Orchard Road**
**Armonk, N.Y. 10504 (US)**

(72) Inventor: **Economy, James**
**6694 Heathfield Drive**
**San Jose, California 95120 (US)**
Inventor: **Lyerla, James Richard**
**675 Sharon Park Drive**
**113, Menlo Park, California 94025 (US)**
Inventor: **Pedersen, Lester Arlyn**
**591 Curie Drive**
**San Jose, California 95123 (US)**

(74) Representative: **Hobbs, Francis John**
**IBM United Kingdom Patent Operations Hursley**
**Park**
**Winchester, Hants, SO21 2JN (GB)**

Courier Press, Leamington Spa, England.

The present invention relates to a process for forming microcircuits. In particular, it is concerned with such a process in which the resistance of a lithographic resist to plasma etching is increased and thereby the density of the resulting microcircuits geometry is increased.

Plasma etching is well known in the art. See, for example, the Journal of Vacuum Science Technology, Vol. 14 No. 1, p. 466, 1977, and Electronics, pages 89—98, May 12, 1977.

In the past, however, lithographic resist systems have been found to provide marginal etch resistance to dry plasma etch processing in the manufacture of microcircuits. Up to the present, thick layers of resist had to be used to ensure adequate protection of the substrate from undesirable etching in unpatterned areas. The density of the resulting device geometry was therefore limited and registration was also adversely affected.

IBM Technical Disclosure Bulletin, Vol. 20 No. 7, Dec. 1977, page 2706 discloses a process for hardening a resist film by treating the film with an oxidizing agent. That reference, however, does not show the use of either sodium hydroxide, or potassium hydroxide, as required by the present invention.

According to the invention there is provided a process for forming a microcircuit comprising the steps of forming on a substrate a resist film of resin, subjecting said resist film to imagewise exposure to radiation followed by development, cross-linking said resist film and exposing said resist film-coated substrate to plasma etching, characterised in that the said resin contains hydrogen replaceable by NaOH or KOH and that the surface of the cross-linked resin film is contacted with an aqueous solution of NaOH or KOH.

The resist film is first prepared by conventional means such as spincoating, baking, exposing and developing. The resist is then subjected to additional cross-linking by whatever means is appropriate to the particular resist. This could be, for example pre-exposure to plasma, or treatment with an acid-formaldehyde solution. Following this cross-linking, the surface of the resist is contacted with an aqueous solution of sodium hydroxide or potassium hydroxide. During this contacting, sodium ions or potassium ions are taken up by the resist. The resist thereby acquires enhanced resistance to etching by commonly used plasma etching methods. The term plasma etching is used here in its broad sense, to include reactive ion etching.

The present invention allows significant reduction in the resist thickness so that as little as 1/10 to 2/3 of the prior art thicknesses need be used.

The surface of the resist system subjected to the present invention can be varied as to depth of penetration of sodium ion or potassium ion, thereby providing a means to control the degrees of resistance to etching, with a concomitant control of etch profiles.

The process of the present invention is applicable to any of a wide variety of resists, particularly those which contain replaceable hydrogen, for example, carboxylic acid groups and phenolic groups. In particular, this approach has given outstandingly good results with resins comprising phenol-formaldehyde resins or derivatives thereof, and with polymers and copolymers of methacrylic acid and/or methacrylic anhydride. In particular, a terpolymer of methyl methacrylate, methacrylic acid and methacrylic anhydride has given outstanding results when used in the present invention.

To remove the metal containing resist, one can use any of several different methods, for example, an oxygen ashing, followed by a water or dilute acid rinse, will remove both the resist and the metal. One could also treat directly with dilute acid to remove the metal ion.

In summary, according to the process of the present invention, microcircuits are formed by first forming on a substrate a resist film of a resin containing hydrogen which reacts with NaOH or KOH. The film is then subjected to lithographic processing by any conventional means, for example imagewise exposure to light to create a circuit pattern of exposed and unexposed areas, and then developing the film by treatment with a selective solvent. The film is then cross-linked, and treated with an aqueous solution of either NaOH or KOH. It is then subjected to plasma ion etching to create the microcircuit.

Example 1

Three 2-micron thick films of a m-cresol/formaldehyde resin with photoactive compound were spin-coated on silicon dioxide surface wafers and heated at 80°C for 15 minutes, then at 130°C for 30 minutes. Two of these films were then cross-linked by reaction in aqueous hydrochloric acid/formaldehyde solution at 85°C for 15 minutes.

One cross-linked film was immersed in 25% aqueous sodium hydroxide solution for one minute. All three films were then heated at a temperature between 170° and 180°C for 30 minutes. The three films were then etched in an 8% oxygen 92% carbontetrafluoride plasma at 73.33 Pascals (0.55 Torr), 200 watts r.f

The film treated with sodium hydroxide in accordance with the present invention exhibited an etch rate of 340Å per minute, as opposed to a rate of 640Å per minute for the other two films.

Example 2

Two quartz disks were overcoated with about two microns of a similar type of resist used in Example 1 above. The disks were heated at 85°C for 30 minutes, then soaked in a standard developer for 2 minutes, and then washed for 5 minutes with water. One of the disks was cross-linked as in Example 1 above, in a solution of 25% aqueous sodium hydroxide for 1 1/2 minutes, and then dipped briefly in water before drying.

Both disks were heated at a temperature of from 185° to 190°C for 30 minutes. The disks were then etched in a diode configured carbon-tetrafluoride plasma.

The etch rate ratios of untreated to treated films were 1.48 at $100\mu$ pressure and 50 watts r.f., 1.31 at $100\mu$ pressure and 100 watts r.f. and 2.16 at $20\mu$ pressure and 50 watts r.f.

Example 3

A silicon wafer was spin coated with a terpolymer of methacrylic acid, methymeth-acrylate and methacrylic anhydride. The coated wafer was heated in an oven at 180°C for 30 minutes in air. It was then soaked for 15 minutes in a 25% v/v solution of diphenyl-dichlorosilane in toluene. It was next rinsed in toluene and then heated on a hot plate for 10 minutes at a temperature between 80° and 90°C. The wafer was then immersed in 0.1 normal aqueous sodium hydroxide and then dipped in deionized water. It was next spin dried and heated at 120°C for 30 minutes.

Plasma etching was carried out in a carbon-tetrafluoride/oxygen discharge at 73.33 Pascals (0.55 torr) and 200 watts r.f. A significant reduction in removal of terpolymer was seen in the treated cases. Only 4000Å units of film was removed in 0.5 hours, while a 2-micron thick untreated film was removed in about 20 minutes. In about 30 minutes the treated film increased in etch rate to a value of about 900Å per minute. This rate was still less than the equilibrium etch rate of untreated terpolymers, which was about 2400Å per minute. Under the plasma etch conditions, two microns of silicon were removed in less than 10 minutes and two microns of $SiO_2$ in about 30 minutes, respectively, thus illustrating the usefulness of the present invention.

Claims

1. A process for forming a microcircuit comprising the steps of forming on a substrate a resist film of resin, subjecting said resist film to image-wise exposure to radiation followed by development, cross-linking said resist film and exposing said resist film-coated substrate to plasma etching, characterised in that the said resin contains hydrogen replaceable by NaOH or KOH and that the surface of the cross-linked resin film is contacted with an aqueous solution of NaOH or KOH.

2. A process as claimed in claim 1, in which the resist comprises a phenol-formaldehyde resin or a derivative thereof.

3. A process as claimed in claim 1, in which the resist comprises methacrylic acid as a monomer or co-monomer.

4. A process as claimed in claim 1, in which the resist comprises methacrylic anhydride as a monomer or co-monomer.

Revendications

1. Procédé pour former un microcircuit comprenant les étapes consistant à former sur un substrat un film photosensible d'une résine, à soumettre ledit film à une exposition à un rayonnement à la manière d'une image puis à un développement, à réticuler ledit film photosensible et à exposer ledit substrat revêtu du film photosensible à une gravure par plasma, caractérisé en ce que ladite résine contient de l'hydrogène remplaçable par NaOH ou KOH et en ce que la surface du film réticulé est mise au contact d'une solution aqueuse de NaOH ou de KOH.

2. Procédé selon la revendication 1, caractérisé en ce que la substance photosensible contient une résine de phénol-formaldéhyde ou un de ses dérivés.

3. Procédé selon la revendication 1, caractérisé en ce que la substance photosensible contient de l'acide méthacrylique sous forme d'un monomère ou d'un co-monomère.

4. Procédé selon la revendication 1, caractérisé en ce que la substance photosensible contient de l'anhydride méthacrylique sous forme d'un monomère ou d'un co-monomère.

Patentansprüche

1. Verfahren zur Ausbildung einer Mikroschaltung mit den Verfahrensschritten der Ausbildung eines Resistfilms aus Harz auf einem Substrat, der bildweisen Bestrahlung des Resistfilms gefolgt von einer Entwicklung, der Vernetzung des Resistfilms und der Plasmaätzung des resistfilmbeschichteten Substrats, dadurch gekennzeichnet, daß das Harz durch NaOH oder KOH austauschbaren Wasserstoff enthält und daß die Oberfläche des vernetzten Harzfilms mit einer wässerigen Lösung von NaOH oder KOH in Berührung gebracht wird.

2. Verfahren nach Anspruch 1, bei welchem der Resist ein Phenolformaldehydharz oder ein Derivat desselben umfaßt.

3. Verfahren nach Anspruch 1, bei welchem der Resist Methacrylsäure als Monomer oder Comonomer umfaßt.

4. Verfahren nach Anspruch 1, bei welchem der Resist Methacrylsäureanhydrid als Monomer oder Comonomer umfaßt.